# FASCICULE DE BREVET EUROPEEN

(11) **EP 3 418 758 B1**
(45) Date de publication et mention de la délivrance du brevet: **26.06.2024**
(21) Numéro de dépôt: 18163974.1
(22) Date de dépôt: 26.03.2018
(51) Int. Cl.: G01R 31/327

(54) **DISPOSITIF ET PROCEDE DE TEST DU FONCTIONNEMENT D'UN APPAREIL DE PROTECTION ET APPAREIL DE PROTECTION COMPORTANT UN TEL DISPOSITIF DE TEST**
VORRICHTUNG UND VERFAHREN FÜR DEN FUNKTIONSTEST EINES SCHUTZGERÄTS, UND SCHUTZGERÄT, DAS EINE SOLCHE TESTVORRICHTUNG UMFASST
DEVICE AND METHOD FOR TESTING THE OPERATION OF A PROTECTION UNIT AND PROTECTION UNIT COMPRISING SUCH A TEST DEVICE

(30) Priorité: 22.06.2017 FR 1755699
(43) Date de publication de la demande: 26.12.2018
(73) Titulaire: Schneider Electric Industries SAS, 92500 Rueil-Malmaison (FR)
(72) Inventeur: BLANCHARD, Pierre, 38050 GRENOBLE (FR); STEPANEK, Jiri, 38050 GRENOBLE (FR); BORDET, Bruno, 38050 GRENOBLE (FR)
(74) Mandataire: Schneider Electric

(56) Documents cités:
- EP-A1- 1 533 880
- DE-A1-102007 007 263
- FR-A1- 2 910 189
- US-A1- 2015 355 273

## Description

La présente invention concerne un dispositif de test du fonctionnement d'un appareil de protection d'un réseau électrique, tel qu'un interrupteur, un relais ou un disjoncteur différentiel. L'invention concerne aussi un appareil de protection d'un réseau électrique comportant un tel dispositif de test. L'invention concerne également un procédé de test d'un appareil de protection.

### ETAT DE LA TECHNIQUE

Les appareils de protection électrique sont largement utilisés dans les installations électriques afin de protéger les biens et les personnes contre des défauts électriques. Ces appareils de protection ont pour fonction, entre autre, d'interrompre l'alimentation électrique d'une portion défaillante du circuit électrique dès qu'un défaut est détecté afin d'isoler la portion défaillante du reste du circuit électrique. Le défaut détecté peut être un court-circuit, une surcharge, un défaut d'isolement à la terre ou un défaut différentiel. Ces appareils de protection disposent généralement d'un moyen de test permettant de vérifier leur bon fonctionnement. Très fréquemment, l'ouverture du circuit électrique est le résultat d'un test positif. Or, il n'est pas toujours souhaitable d'interrompre l'alimentation des charges électriques présentes sur la portion de circuit électrique en aval de l'appareil de protection, celles-ci pouvant être, par exemple, des organes de sécurité ou des machines nécessitant une configuration au démarrage. Une difficulté consiste donc à tester l'appareil de protection, sans perturber son fonctionnement et sans générer d'interruption de l'alimentation électrique des charges alimentées.

On connait le document WO 2009/120323 A1 décrivant un dispositif de test simulant un défaut d'isolement à la terre. La sortie de déclenchement est inhibée pendant le test afin de ne pas ouvrir le circuit électrique. Un inconvénient d'un tel dispositif est de rendre la surveillance du circuit électrique inopérante pendant toute la durée du test. De plus, le test est effectué périodiquement ce qui rend la protection inopérante périodiquement.

Le document US 2010 073002 A1 décrit un dispositif de test permanent pour un appareil de protection de défaut à la terre. Dans ce dispositif, un courant différentiel est généré en permanence et détecté par un circuit de mesure. Cette solution convient pour un appareil dont le seuil de fonctionnement est bas, par exemple 30 mA pour une protection des personnes, mais devient difficile à mettre en oeuvre si le dispositif de protection dispose d'un seuil de déclenchement élevé, par exemple 5A. En effet, le courant de test devient lui aussi élevé et génère un échauffement de l'appareil. De la publication EP 1 936 771 A1 est connu un dispositif de test avec impulsions et changement de seuil de déclenchement et temporisation pour minimiser la dépense énergétique. Un tel dispositif de test n'effectue donc pas le test de tous les seuils de déclenchement proposés par l'appareil.

De son côté, US 2015 0355273 A1, qui peut être considéré comme l'état de la technique le plus proche de l'invention définie à la revendication 1 annexée, divulgue un appareil de protection d'un réseau électrique, qui comprend un transformateur de courant dont le circuit magnétique entoure des conducteurs électriques dans lesquels circule un courant primaire. Cet appareil de protection comprend également des premier et second enroulements secondaires, enroulés sur le circuit magnétique. Le premier enroulement secondaire est connecté à un dispositif de commande, plus précisément à une unité de traitement de ce dernier, qui filtre et/ou amplifie le courant électrique circulant dans le premier enroulement secondaire. Le dispositif de commande comporte également une unité de détection, qui est connectée à l'unité de traitement et qui détecte le courant électrique, filtré et/ou amplifié. Le dispositif de commande comporte aussi une unité de déclenchement, qui est connectée à l'unité de détection et qui est configurée pour transmettre un signal de commande approprié à un commutateur de l'appareil de protection lorsque l'intensité du courant détecté par l'unité de détection dépasse une valeur seuil qui est mémorisée par l'unité de déclenchement. Le dispositif de commande comporte par ailleurs une unité de test, qui est reliée au second enroulement secondaire et qui génère dans ce dernier un courant de test. Ce courant de test peut être continu, le cas échéant pulsé, et/ou alternatif avec une fréquence de, par exemple, 50 Hz ou de 60 Hz ou de plusieurs kHz. Le courant de test induit un flux de courant dans le premier enroulement secondaire, ce flux de courant étant filtré et/ou amplifié par l'unité de traitement et détecté à l'aide de l'unité de détection. L'unité de test peut être configurée pour que le courant de test provoque, dans le premier enroulement secondaire, un courant électrique dont l'intensité est inférieure à la valeur seuil précitée.

La présente invention vise donc à remédier à ces inconvénients en permettant de tester le bon fonctionnement d'un appareil de protection quel que soit le seuil de déclenchement sélectionné, sans générer d'ouverture du circuit électrique et sans interrompre la fonction de protection.

### EXPOSE DE L'INVENTION

Pour cela, l'invention a pour objet un dispositif de test, tel que défini à la revendication 1.

Des caractéristiques avantageuses du dispositif de test conforme à l'invention sont énoncées aux revendications 2 à 12.

L'invention a également pour objet un appareil de protection d'un réseau électrique, tel que défini à la revendication 12.

L'invention a également pour objet un procédé de test, tel que défini à la revendication 13.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 représente, sous forme d'un schéma bloc, un dispositif de test d'une chaîne de mesure de courant d'un appareil de protection électrique selon un mode de réalisation préférentiel de l'invention,
- la figure 2 représente un schéma d'un circuit pour générer un train d'impulsions d'amplitude constante dans un enroulement secondaire d'un capteur de courant,
- la figure 3 illustre une courbe de réponse en fréquence d'un filtrage passe-bas effectué par un circuit de mesure de courant d'un appareil de protection électrique,
- les figures 4a et 4b représentent des trains d'impulsions mono-fréquence générés par le dispositif de test selon un mode de réalisation préférentiel,
- la figure 4c représente un train d'impulsions comportant un exemple de motif spécifique généré par le dispositif de test selon une variante de réalisation,
- la figure 5 montre l'évolution du résultat d'un calcul d'une valeur efficace d'un signal de mesure pendant une application d'un signal de test représenté en figure 4c,
- la figure 6 est une représentation schématique d'un appareil de protection comportant le dispositif de test de l'invention, et
- la figure 7 représente un organigramme d'un procédé de test d'un appareil de protection comportant un dispositif de test selon l'invention.

### DESCRIPTION DETAILLEE DE MODES DE REALISATION PREFERES

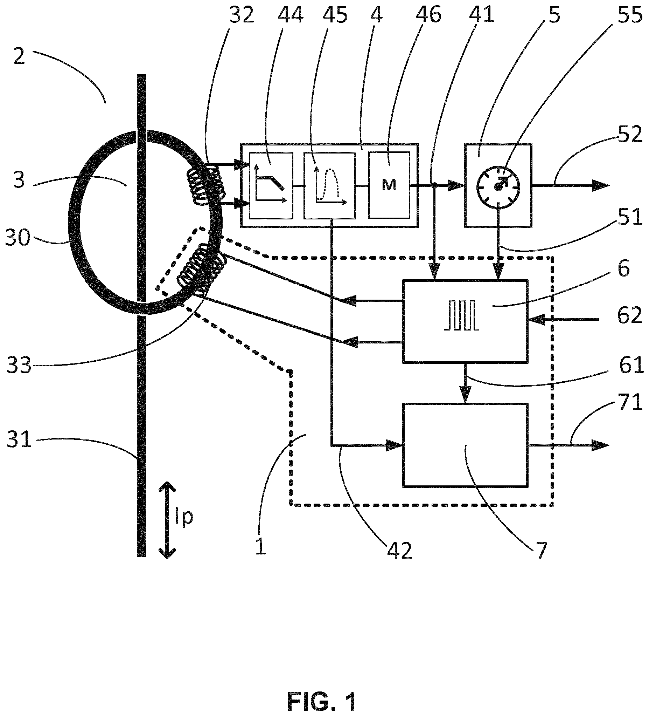

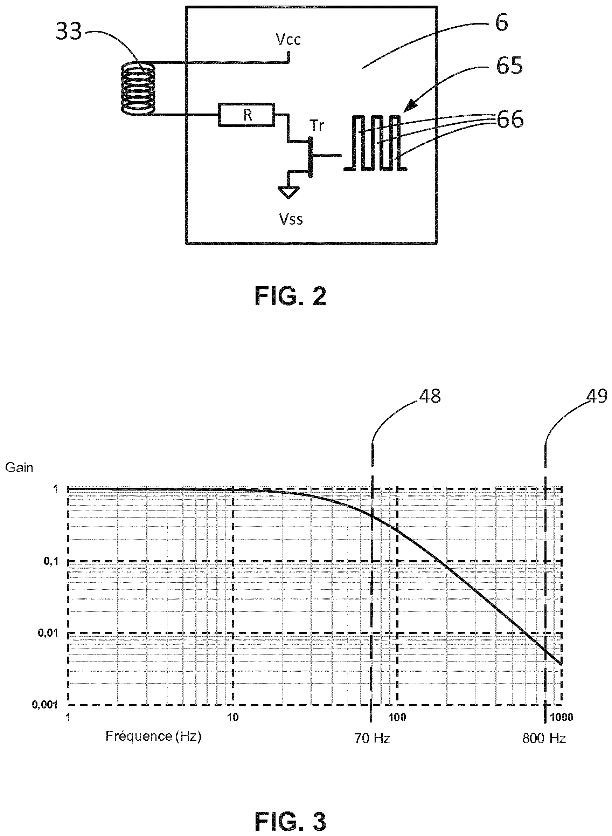

La figure 1 représente, sous forme d'un schéma bloc, un dispositif de test 1 d'une chaîne de mesure de courant d'un appareil de protection électrique 2 selon un mode de réalisation préférentiel de l'invention. L'appareil de protection 2 comporte un transformateur de courant 3 composé d'un circuit magnétique 30 disposé autour d'au moins un conducteur de courant 31 dans lequel circule un courant primaire Ip. Le, au moins un, conducteur de courant 31 forme ainsi un circuit primaire du transformateur de courant 3. On dispose d'un seul conducteur 31 dans le cas d'une protection contre un court-circuit dans une installation électrique monophasée. On dispose de deux conducteurs 31 dans le cas d'une protection différentielle dans une installation électrique monophasée, et trois ou quatre conducteurs 31 dans le cas d'une protection différentielle dans une installation électrique triphasée avec ou sans neutre. Le nombre de conducteurs 31 n'a pas d'influence sur le fonctionnement de l'invention puisque le transformateur de courant 3 est sensible à la somme vectorielle des courants circulant dans le ou les conducteurs 31. En présence de plus d'un conducteur de courant 31, le courant primaire Ip correspond à un courant différentiel. Le transformateur de courant 3 comprend un premier enroulement secondaire 32 enroulé sur le circuit magnétique 30. Le courant primaire Ip génère un champ magnétique dans le circuit magnétique 30 du transformateur 3 ce qui induit un signal à l'image du courant primaire Ip dans le premier enroulement secondaire 32. Cet enroulement fournit un signal électrique proportionnel au courant Ip, composé des mêmes fréquences que le courant Ip. Le coefficient de proportionnalité est égal au nombre de spires du conducteur primaire 31, généralement égal à un, divisé par le nombre de spires du premier enroulement secondaire 32. La fréquence principale du courant Ip correspond à la fréquence du réseau électrique qui est généralement 50 ou 60 Hertz. Un circuit de mesure 4 est connecté au premier enroulement secondaire 32. Le circuit de mesure 4 comporte un filtre 44 pour effectuer un filtrage passe-bas du signal délivré par le premier enroulement secondaire 32 afin d'éliminer les harmoniques haute fréquence contenues dans le courant primaire Ip. La figure 3 illustre la courbe de réponse en fréquence du filtre 44. La fréquence de coupure est préférentiellement comprise entre 60 et 120 Hertz. Le filtrage passe-bas est rendu également nécessaire avant de procéder à un échantillonnage du signal délivré par le premier enroulement secondaire 32. Le filtre passe bas 44 est un filtre du deuxième ordre. L'échantillonnage du signal délivré en sortie du filtre 44 est exécuté par le circuit 45, auquel il est connecté, pour fournir un signal 42 représentatif du courant primaire. Le signal 42 correspond à la numérisation du signal délivré par le premier enroulement secondaire 32 après filtrage des hautes fréquences. Le circuit de mesure 4 effectue également une mesure 41 du courant primaire Ip, au moyen du circuit 46, en utilisant les échantillons fournis par le circuit 45. La mesure 41 du courant primaire Ip est préférentiellement une valeur efficace du courant primaire Ip. Ladite mesure peut également être une valeur crête ou une valeur moyenne du courant primaire Ip. La mesure 41 du courant primaire Ip est fournie à un circuit de déclenchement 5. Le circuit de déclenchement 5 comporte des moyens 55 pour sélectionner un seuil de déclenchement Sd parmi plusieurs seuils Sd possibles, par exemple : 5 mA, 30 mA, 100 mA, 1A, 5A, 10A ou 100A, cette liste étant non limitative. Le moyen de sélection 55 peut être un bouton, un commutateur ou encore un menu déroulant sur un écran, cette liste étant non limitative. Quand la mesure 41 du courant primaire est supérieure au seuil Sd sélectionné, le circuit de déclenchement 5 émet un ordre de déclenchement 52 à destination d'un actionneur afin d'interrompre la circulation du courant Ip.

Le transformateur de courant 3, le circuit de mesure 4 et le circuit de déclenchement 5 font partie des éléments essentiels de l'appareil de protection.

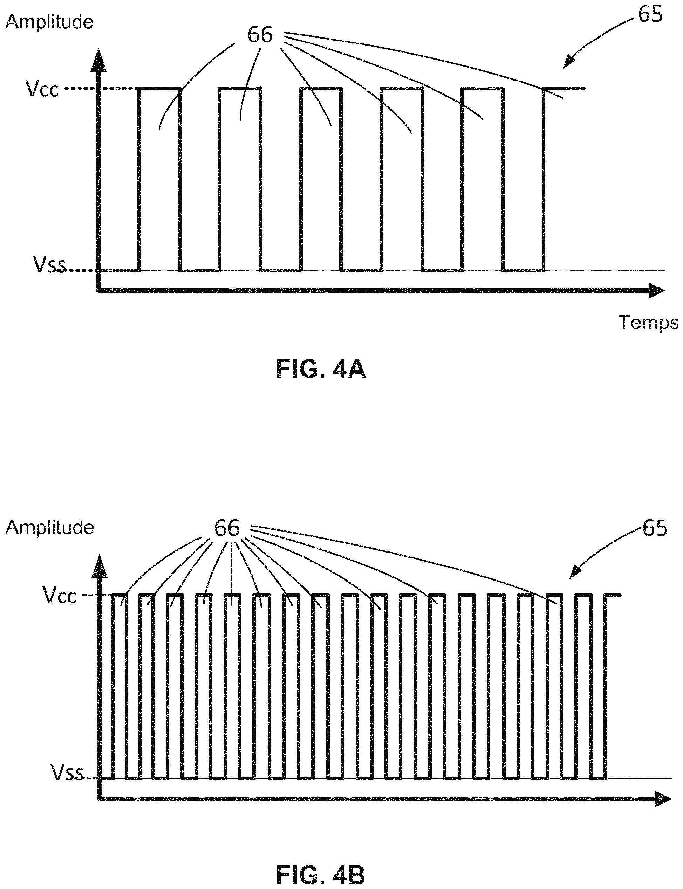

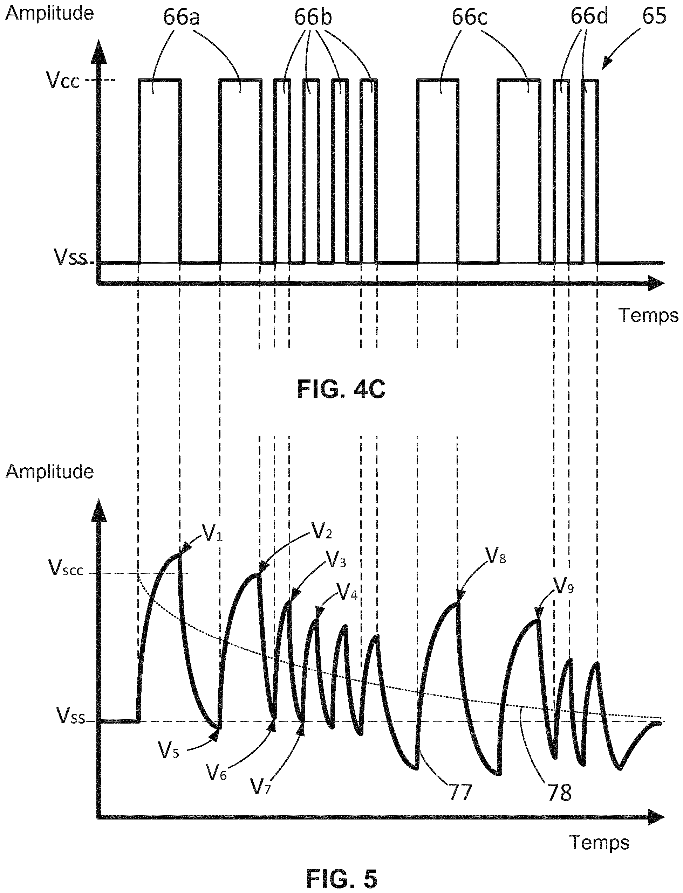

L'invention a pour objet une vérification de leur bon fonctionnement au moyen d'un dispositif de test. Pour cela, un générateur 6 est agencé pour générer au moins un train d'impulsions 65 dans un deuxième enroulement secondaire 33 du transformateur de courant 3. Les figures 4A, 4B et 4C représentent des exemples de train d'impulsion 65. Un champ magnétique est ainsi créé dans le circuit magnétique 30 du transformateur 3 ce qui induit un signal à l'image du train d'impulsions 65 dans le premier enroulement secondaire 32, ledit signal étant superposé au signal correspondant au courant primaire Ip. Le circuit de mesure 4 traite ainsi le train d'impulsions 65 de la même façon qu'il traite le signal correspondant au courant primaire Ip. Dans la suite de la description, nous considérerons que le signal représentatif du courant primaire 42 comporte un signal à l'image du courant primaire Ip sur lequel est superposé un signal à l'image du train d'impulsions 65 lorsque celui-ci est émis. Un circuit de traitement 7 est connecté au circuit de mesure 4 pour recevoir le signal représentatif du courant primaire 42 issu du circuit d'échantillonnage 45. Le circuit de traitement 7 est également connecté au générateur 6 pour recevoir un signal 61 à l'image du train d'impulsions 65 émis par le générateur 6. Le circuit de traitement 7 identifie une présence du train d'impulsions 65 représenté par le signal 61 dans le signal représentatif du courant primaire 42. Pour cela, le circuit de traitement 7 compare le signal représentatif du courant primaire 42 et le signal 61 à l'image du train d'impulsions 65. Quand le circuit de traitement 7 identifie la présence du train d'impulsions 65 dans le signal représentatif du courant primaire 42, ladite présence du train d'impulsion étant synchrone avec le signal 61 à l'image du train d'impulsions 65, alors le test est positif : le transformateur de courant 3, le filtre 44 et le circuit d'échantillonnage 45 sont opérationnels.

Il est important que le dispositif de test ne perturbe pas le fonctionnement de l'appareil de protection électrique 2, et tout particulièrement, le fonctionnement du dispositif de test ne doit pas provoquer un déclenchement de l'appareil de protection 2. D'autre part, il est intéressant de tester le fonctionnement de l'appareil de protection 2 en conservant le seuil de déclenchement Sd choisi. Ainsi ledit seuil n'est pas modifié , même temporairement, au cours du test et tous les seuils peuvent être testés individuellement. Enfin il est économiquement intéressant que le dispositif de test soit simple et peu coûteux. Pour cela, le générateur 6 émet un train d'impulsions 65, composé d'impulsions 66 ayant une amplitude constante quel que soit le seuil de déclenchement Sd choisi. La figure 2 représente un schéma du circuit de génération du train d'impulsions 65 dans le deuxième enroulement secondaire 33. Le deuxième enroulement secondaire 33 est connecté entre un premier point de référence d'alimentation Vcc, correspondant à une source d'alimentation en tension continue disponible dans le générateur 6, et un second point de référence d'alimentation Vss, en série avec une résistance R de limitation de courant, permettant de fixer le nombre d'ampère-tours pour le deuxième enroulement secondaire 33, et un interrupteur Tr. L'interrupteur Tr est préférentiellement un transistor auquel est appliqué un motif correspondant au train d'impulsions 65 sur l'électrode de commande. L'interrupteur Tr commande ainsi la circulation d'un courant dans l'enroulement secondaire 33 pendant la durée de chaque impulsion 66 du train d'impulsions 65. L'amplitude de la tension Vcc appliquée est constante et indépendante du seuil de déclenchement Sd. De même, le courant circulant dans le deuxième enroulement secondaire 33, quand l'interrupteur Tr est fermé, est constant et indépendant du seuil de déclenchement Sd. Il est à noter que le train d'impulsions 65, ainsi généré, contient une composante continue Uc quand le point de référence d'alimentation Vss correspond à un zéro Volt d'alimentation. Une détection de la composante continue peut être utilisée en variante pour l'identification du signal de test comme il sera décrit ultérieurement. L'amplitude des impulsions et le nombre de spires du deuxième enroulement secondaire 33 sont dimensionnés pour permettre le test du fonctionnement sur le seuil de déclenchement Sd le plus élevé. Dans ce cas, la fréquence des impulsions 66 est choisie proche de la fréquence du réseau électrique. Préférentiellement, pour un seuil de déclenchement de 5 Ampères, la fréquence des impulsions 66 sera égale à 70 Hertz. Un tel train d'impulsions est illustré en figure 4A. Préférentiellement, pour un seuil de déclenchement supérieur à 1 Ampère, la fréquence des impulsions 66 sera inférieure à 100 Hertz. Afin que le train d'impulsions 65 ne provoque pas un déclenchement de l'appareil de protection quand le seuil de déclenchement Sd est réglé sur une valeur faible, 30 mA par exemple, le signal mesuré par le circuit de mesure 46 doit être inférieur au seuil Sd. Pour cela, selon l'invention, quand le seuil Sd est réglé sur une valeur faible, la fréquence des impulsions 66 est augmentée. Préférentiellement, pour un seuil de déclenchement égal à 30 mA, la fréquence des impulsions 66 sera de l'ordre de 800 Hertz. Un tel train d'impulsions est illustré en figure 4B. La figure 3 illustre la courbe de réponse en fréquence du filtre 44 sur laquelle est indiquée, au moyen d'un repère vertical 48, la fréquence de 70 Hz utilisée pour le seuil de déclenchement Sd égal à 5A. Un repère vertical 49 marque la fréquence de 800 Hz utilisée pour le seuil de déclenchement Sd égal à 30 mA. Le filtre 44 atténue peu la fréquence de 70 Hz. Le train d'impulsions 65 émis par le générateur dans le second enroulement secondaire 33 et reçu par le premier enroulement secondaire 32 sera donc peu atténué. En revanche le filtre 44 atténue fortement la fréquence de 800 Hz comme l'indique le repère vertical 49. Le train d'impulsions 65 émis par le générateur dans le second enroulement secondaire 33 est atténué de façon à rester inférieur au seuil de déclenchement Sd et ainsi ne pas générer un déclenchement du dispositif de protection. Le choix de la fréquence des impulsions 66, la fréquence de coupure du filtre 44, l'ordre du filtre 44, le nombre de spires et l'inductance des premiers et deuxième enroulements, permettent de définir le niveau de signal reçu par le circuit de mesure 46 et par conséquent de définir un profil de fréquences tel que la mesure du train d'impulsions 65 après passage dans le filtre 44 soit inférieure au seuil de déclenchement Sd. D'une façon plus générale, pour un seuil de déclenchement Sd élevé, la fréquence des impulsions 66 sera basse et pour un seuil de déclenchement Sd faible, la fréquence des impulsions 66 sera élevée. L'étagement des fréquences en correspondance avec les seuils Sd est tel que la fréquence des impulsions 66 correspondant à un seuil de déclenchement Sd donné est supérieure à la fréquence des impulsions correspondant à un seuil de déclenchement Sd plus élevé. Ainsi la difficulté consistant à tester le transformateur de courant 3 et le circuit de mesure 4 au moyen d'un train d'impulsions 65 quel que soit le seuil de déclenchement Sd choisi est résolue. Cette solution a l'avantage de ne pas nécessiter une commutation du seuil de déclenchement ou de commutation de la charge du premier enroulement secondaire 32. L'énergie nécessaire à la génération du train d'impulsions 65 est constante, pour un rapport cyclique donné, quelle que soit la fréquence des impulsions 66 et quel que soit le seuil de déclenchement Sd sélectionné. Le train d'impulsions 65 peut être composé d'un nombre prédéfini d'impulsions 66 ou encore le train d'impulsions 65 peut être composé d'impulsions 66 émises pendant une durée prédéfinie, par exemple 100 millisecondes quand le seuil de déclenchement Sd est égal à 30 mA et 400 millisecondes quand le seuil de déclenchement Sd est supérieur ou égal à 100 mA. Le dispositif de test émet préférentiellement un train d'impulsions 66 quand une demande de test 62 est activée, préférentiellement au moyen d'un bouton poussoir accessible par un opérateur, ou au moyen d'un bus de communication. En variante, une demande de test peut être activée par le générateur 6, cycliquement et automatiquement, par exemple une fois par heure ou une fois par jour. Préférentiellement, un intervalle minimal de deux secondes est nécessaire entre deux trains d'impulsion 65 consécutifs.

Le générateur 6 est relié au circuit de déclenchement 5 par une liaison 51 pour l'acquisition de la valeur du seuil de déclenchement Sd sélectionné. Ainsi le générateur 6 peut générer le train d'impulsion 65 spécifique correspondant au seuil de déclenchement Sd sélectionné.

Un appareil de protection électrique peut être installé sur un réseau comportant une ou plusieurs charges électroniques telles que variateur de vitesse, convertisseur de tension ou de fréquence. De telles charges génèrent des harmoniques sur le réseau pouvant être interprétées par le circuit de traitement 7 comme représentatives de la fréquence des impulsions 66 émises par le générateur 6. En variante le générateur peut émettre un train d'impulsions comportant un motif particulier, reconnaissable par le circuit de traitement 7. Une infinité de motifs différents peuvent être définis. Des motifs simples sont illustrés en figure 4A et 4B. Un exemple de motif plus complexe est illustré en figure 4C. Il comporte une ou plusieurs impulsions 66a et 66c à une fréquence donnée puis une ou plusieurs impulsions 66b et 66d à une fréquence différente. Un motif peut comporter un nombre d'impulsions variable, mais le nombre d'impulsions fait partie de la définition du motif : si le générateur 6 émet un train d'impulsion 65 composé de dix impulsions 66 ayant une fréquence de 800 Hz et que le circuit de traitement identifie vingt impulsions ayant une fréquence 800 Hz, le test doit être considéré comme négatif car une source perturbatrice à 800 Hz est manifestement présente. Un motif spécifique permet d'identifier sans erreur la présence du train d'impulsion 65 contenu dans le signal reçu par le premier enroulement secondaire 32, même si ledit signal contient beaucoup d'harmoniques parasites. On entend par « identifier une présence du train d'impulsions 65 dans le signal représentatif du courant primaire 42 » une reconnaissance du motif spécifique correspondant au seuil de déclenchement Sd sélectionné, par exemple tel que représenté en figure 4C, pour un seuil de déclenchement Sd est égal à 100 mA, une série de deux impulsions 66a ayant une fréquence de 400 Hz suivi de quatre impulsions 66b ayant une fréquence de 800 Hz suivi de deux impulsions 66c de fréquence 400 Hz et enfin deux impulsions 66d de fréquence 800 Hz.

Le circuit de traitement 7 effectue préférentiellement l'identification du train d'impulsion 65 présent sur le signal représentatif du courant primaire 42 au moyen d'une comparaison point à point entre le train d'impulsions 65 émis par le générateur 6, par exemple tel que représenté en figure 4C, et le signal correspondant représentatif du courant primaire 42 tel que représenté en figure 5. Suite à l'émission de la première impulsion de test 66a, il apparait un front de montée, jusqu'à un maximum V1, sur le signal représentatif du courant primaire 42. Puis, quand la première impulsion 66a tombe à zéro, un front de descente jusqu'à un minimum V5 est présent sur le signal représentatif du courant primaire 42. Il en est de même pour les impulsions suivantes. Ainsi, la détection d'un front de montée ou d'un front de descente sur le signal représentatif du courant primaire 42 en synchronisme avec l'émission d'une impulsion de test 66 est une preuve que les impulsions présentes sur le signal 42 proviennent du générateur 6 et non d'une source parasite externe au dispositif.

Un moyen complémentaire d'identification du train d'impulsion 65 présent sur le signal représentatif du courant primaire 42 peut être obtenu en comparant l'amplitude des impulsions présentes sur le signal représentatif du courant primaire 42 en fonction de la fréquence de ces mêmes impulsions. Ainsi, les impulsions 66a ayant une fréquence de 400 Hz seront moins atténuées par le filtre 44 que les impulsions 66b ayant une fréquence de 800 Hz. Sur le signal représentatif du courant primaire 42 illustré en figure 5, les amplitudes V1-V5 et V2-V6 correspondant aux impulsions 66a de fréquence 400 Hz sont plus importantes que les amplitudes V3-V7 et V4-V7 correspondant aux impulsions 66b de fréquence 800 Hz. La différence d'amplitude est définie par l'atténuation du filtre 44 aux fréquences 400Hz et 800 Hz.

Une autre possibilité d'identification de la présence du train d'impulsions 65 dans le signal représentatif du courant primaire 42 est d'effectuer une décomposition spectrale telle qu'une transformée de Fourier afin d'identifier les différentes fréquences et amplitudes respectives contenues dans le signal 42. D'autres moyens peuvent être utilisés tels que convolution ou encore corrélation des signaux 42 et 61. Les calculs nécessaires à l'identification sont effectués, par exemple, au moyen d'un microcontrôleur du circuit de traitement 7.

Une possibilité complémentaire pour favoriser l'identification du train d'impulsion 65 présent sur le signal représentatif du courant primaire 42 peut être obtenue en utilisant un motif composé d'impulsions 66 dont le rapport cyclique est différent de 50%. Par exemple une impulsion peut avoir une amplitude Vcc pendant 60% de la période et une amplitude nulle pendant les 40% de temps restant.

En variante, le circuit de traitement 7 possède un module pour détecter la présence de la composante continue Uc présente dans le signal de test, indépendamment ou en complément à la détection de la fréquence des impulsions 66 ou du motif contenu dans le train d'impulsions 65. Par principe, le transformateur de courant 3 ne transforme pas le courant continu et se comporte comme un filtre passe-haut. Cependant, un front d'une impulsion de courant continu sera transmis au travers des enroulements du transformateur. Cette propriété est utilisée pour détecter la présence de composante continue Uc présente dans le signal de test. Quand la première impulsion 66a est transmise par le circuit magnétique 30 du transformateur 3, le signal représentatif du courant primaire 42 comporte un front de montée dont le potentiel de départ est Vss et l'amplitude maximale est V1. Puisque le circuit magnétique filtre toute composante continue, l'amplitude des impulsions sur le signal représentatif du courant primaire 42 va progressivement se centrer sur le potentiel Vss et l'amplitude V2, V8, V9 des impulsions suivantes passe en dessous du seuil Vscc. La décroissance suit une loi approximativement exponentielle décroissante, illustrée par la courbe 78 sur la figure 5, caractéristique de la présence d'une composante continue. Cette loi de décroissance peut être utilisée pour identifier l'émission d'un train d'impulsions 65. Un seuil Vscc est prédéterminé à une valeur inférieure à V1 et supérieure à l'un des maximums V2, V3 ou V4. Un module du circuit de traitement 7 identifie la présence de la composante continue dans le signal représentatif du courant primaire 42 par détection d'un franchissement du seuil Vscc par le signal représentatif du courant primaire 42. Ledit franchissement caractérise la présence d'une composante continue liée à l'émission d'un train d'impulsions 65 par le générateur 6 et par conséquent vérifie le bon fonctionnement de la chaîne de mesure de courant de l'appareil de protection électrique 2.

Le circuit de traitement 7 du dispositif de test 1 dispose d'une sortie pour émettre un signal d'alerte 71 en l'absence d'identification du train d'impulsions 65 ou en l'absence de détection de la composante continue Uc dans le signal représentatif du courant primaire 42 quand le générateur 6 génère un train d'impulsions 65 dans le deuxième enroulement secondaire 33. Le signal d'alerte 71 permet d'informer l'utilisateur d'un défaut de fonctionnement sans générer un déclenchement de l'appareil de protection électrique 2. De cette façon, la continuité de service est assurée et l'utilisateur pourra programmer une opération de maintenance sur le matériel défaillant à un moment favorable.

Les fonctions du générateur 6 et du circuit de traitement 7 sont préférentiellement réalisées au moyen de programmes informatiques exécutés par un ou plusieurs microprocesseurs. Pour des raisons de dissipation de puissance, le transistor Tr du générateur 6 peut être un composant connecté à l'extérieur du microprocesseur. Le générateur 6 et le circuit de traitement 7 peuvent également être intégrés dans un dispositif numérique ou analogique intégrant d'autres fonctions. De préférence, le générateur 6 et le circuit de traitement 7 font partie d'un ensemble séparé de l'unité contenant le circuit de mesure 4 et le circuit de déclenchement 5 afin d'offrir une meilleure sûreté de fonctionnement. Indirectement, le dispositif de test 1 permet de vérifier la bonne alimentation des circuits de mesure 4 et de déclenchement 5. En variante, le filtre 44 peut être placé, en tout ou partie, entre la sortie du générateur 6 et le deuxième enroulement secondaire 33. Cette variante sera utilisée quand le filtre 44 ne présente pas les caractéristiques nécessaires à une réponse en fréquence telle que représentée en figure 3. Il sera ainsi possible d'apporter une correction sur la réponse en fréquence de la chaine de détection et de test composée par le générateur 6, le transformateur de courant 3 et le circuit de mesure 4.

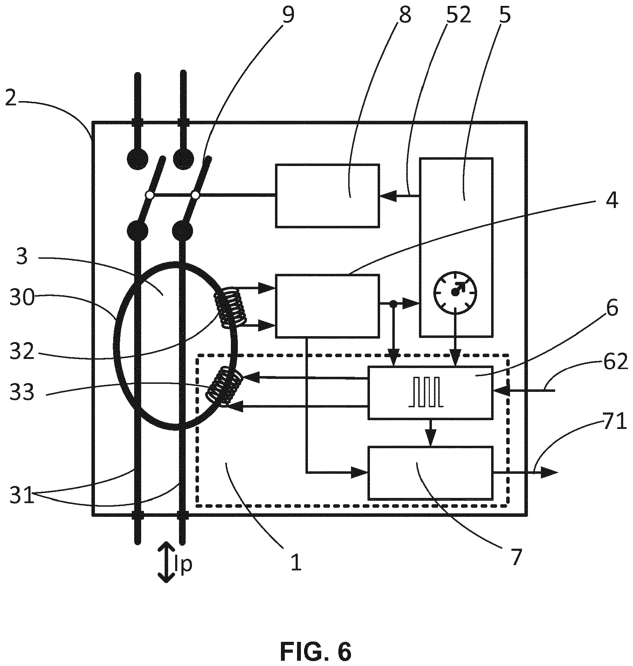

L'invention porte également sur un appareil de protection 2 d'un réseau électrique comportant un dispositif de test 1 tel que décrit précédemment. Ledit appareil de protection 2, représenté schématiquement en figure 6, comporte un transformateur de courant 3 délivrant un signal représentatif d'un courant Ip circulant dans deux conducteurs de courant 31. Le transformateur de courant 3 ainsi décrit est un capteur de courant différentiel, délivrant un signal représentatif d'une différence de courant circulant dans les conducteurs 31, ledit signal étant fourni à un circuit de mesure 4 et à un circuit de déclenchement 5 tels que décrits précédemment. Quand la mesure 41 du courant primaire Ip est supérieure au seuil de déclenchement Sd, le circuit de déclenchement 5, relié à un actionneur 8, envoie un signal de déclenchement 52 à l'actionneur 8 pour activer ledit actionneur. L'actionneur 8 est un organe de déclenchement agencé pour actionner l'ouverture d'un interrupteur de courant 9 afin d'interrompre la circulation du courant Ip dans les conducteurs 31.

L'appareil de protection 2 est équipé d'un dispositif de test tel que décrit précédemment : un générateur 6 émet un train d'impulsions 65 dans un enroulement secondaire 33 du transformateur de courant 3 et détecte et identifie, au moyen d'un circuit de traitement 7, la présence du train d'impulsions dans un signal représentatif du courant primaire 42. Un signal d'alerte 71 est émis en l'absence d'identification du train d'impulsions 65 ou en l'absence de détection de la composante continue Uc dans le signal représentatif du courant primaire 42 quand le générateur 6 génère un train d'impulsions 65 dans le deuxième enroulement secondaire 33. Le signal d'alerte 71 pourra être utilisé, selon le besoin de l'utilisateur, pour émettre un message d'alerte vers un superviseur ou actionner un organe de signalisation ou de déclenchement.

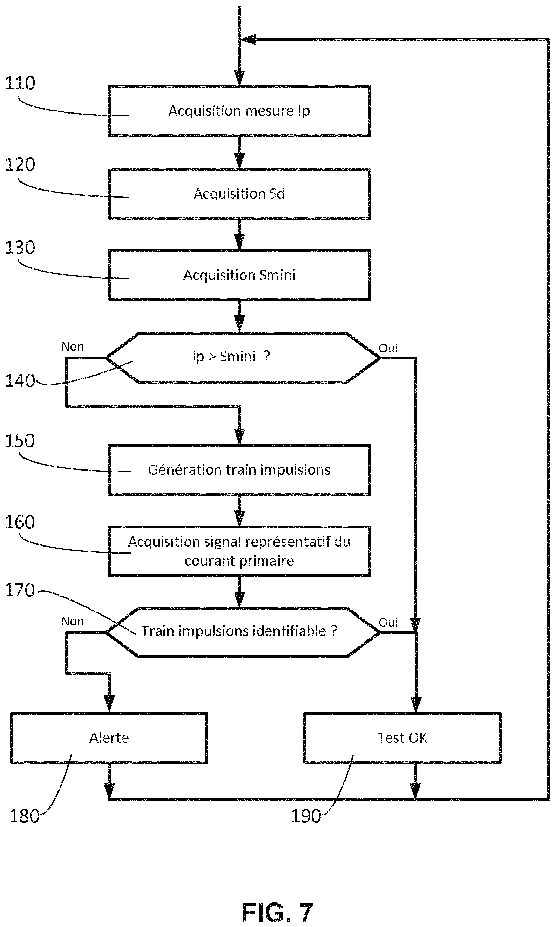

Le dispositif de test 1 peut émettre périodiquement ou continuellement un ou plusieurs trains d'impulsion de test 65. Le train d'impulsions 65 vient s'ajouter au signal généré par le courant primaire Ip dans le premier enroulement secondaire 32. Si le signal généré par le courant primaire Ip est légèrement inférieur au seuil de déclenchement Sd, l'ajout du signal supplémentaire généré par le train d'impulsions 65 peut faire passer la mesure 41 du courant primaire au-dessus du seuil Sd sélectionné et donc provoquer un ordre de déclenchement 52. Pour éviter un tel déclenchement intempestif, l'invention comporte également un procédé de test d'un appareil de protection comportant un dispositif de test tel que décrit précédemment. Un organigramme du procédé de test est représenté en figure 7. Le procédé comporte une étape d'acquisition 110 d'une mesure 41 du courant primaire Ip ; puis, au cours d'une étape 120, le procédé comporte une étape d'acquisition d'une valeur de seuil de déclenchement sélectionné Sd. Le procédé comporte ensuite une étape 130 au cours de laquelle un seuil de courant minimal Smini est déterminé. Le seuil de courant minimal Smini est prédéterminé et associé à chacun des seuils de déclenchement Sd. A titre d'exemple :
- pour un seuil de déclenchement Sd égal à 30 mA, le seuil minimal Smini est égal à 6 mA,
- pour un seuil Sd égal à 100 mA, Smini est égal à 12 mA, et
- pour un seuil Sd égal à 1 A, Smini est égal à 50 mA.

Le seuil Smini peut aussi être défini comme une fraction du seuil de déclenchement Sd, par exemple Smini = 15% x Sd. Le procédé comporte ensuite une étape 140 de comparaison de la mesure du courant primaire 41 au seuil de courant minimal Smini. Si la mesure du courant primaire 41 est supérieure à Smini, cela signifie qu'un courant primaire Ip, d'une amplitude au moins égale à Smini, circule dans le conducteur primaire 31. Une telle information est, en soi, la signification du bon fonctionnement du transformateur de courant 3, du circuit de mesure 4 et du circuit de déclenchement 5. Il n'est donc pas nécessaire d'effectuer le test de fonctionnement ce qui évite un déclenchement intempestif, tel que décrit précédemment, quand le courant primaire Ip est légèrement inférieur au seuil de déclenchement Sd. Le procédé passe alors à une étape 190 correspondant à un test positif pouvant être marqué par l'activation d'une signalisation sur le dispositif de test 1.

Si, au cours du test à l'étape 140, la mesure du courant primaire 41 est inférieure au seuil de courant minimal Smini, cela signifie qu'un faible courant primaire Ip, d'une amplitude inférieure à Smini, circule dans le conducteur primaire 31, ou que le courant primaire Ip est nul ou encore que le transformateur de courant 3 ou le circuit de mesure 4 est défectueux. Dans ce cas, le procédé passe à une étape 150 dans laquelle au moins un train d'impulsions 65 spécifiques au seuil de déclenchement sélectionné Sd est généré. Ensuite, à l'étape 160, une acquisition d'un signal représentatif du courant primaire 42 est effectuée. Puis, à l'étape 170, une identification d'une présence du train d'impulsions 65 dans le signal représentatif du courant primaire 42 est effectuée par une ou plusieurs méthodes décrites précédemment. Si l'identification ou la détection de la composante continue est négative, alors le procédé passe à l'étape 180 au cours de laquelle un signal d'alerte 71 est généré. Sinon, le test est positif. A l'issue des étapes 180 et 190, le procédé retourne à l'étape 110 pour un nouveau cycle de test.

Le procédé de test est exécuté conjointement par le générateur 6 et le circuit de traitement 7.

Un tel procédé de test permet de tester le bon fonctionnement de tout ou partie d'une chaîne de traitement du signal d'un appareil de protection quel que soit le seuil de déclenchement sélectionné, sans provoquer d'ouverture intempestive du circuit électrique.

## Revendications

1. Dispositif de test (1) du fonctionnement d'un appareil de protection (2) d'un réseau électrique,
ledit appareil de protection (2) comportant :
- un transformateur de courant (3) composé d'un circuit magnétique (30) disposé autour d'au moins un conducteur de courant (31) dans lequel circule un courant primaire (Ip) formant un circuit primaire, ledit transformateur comprenant un premier enroulement secondaire (32) enroulé sur le circuit magnétique (30),
- un circuit de mesure (4), connecté au premier enroulement secondaire (32), le circuit de mesure comportant un filtre passe-bas du deuxième ordre (44) et étant agencé pour fournir, après filtrage par le filtre passe-bas du deuxième ordre, un signal représentatif du courant primaire (42) et une mesure du courant primaire (41), et
- un circuit de déclenchement (5), relié au circuit de mesure (4), comportant des moyens de sélection d'un seuil de déclenchement (55),
et ledit dispositif de test (1) comportant :
- un deuxième enroulement secondaire (33) enroulé sur le circuit magnétique (30),
- un générateur (6), relié au circuit de déclenchement (5) pour faire l'acquisition du seuil de déclenchement sélectionné (Sd), et agencé pour générer un train d'impulsions (65) dans le deuxième enroulement secondaire (33) selon un profil de fréquences tel que la mesure du train d'impulsions (65) après passage dans le filtre passe-bas du deuxième ordre (44) soit inférieure au seuil de déclenchement sélectionné (Sd), et
- un circuit de traitement (7), connecté au circuit de mesure (4) et au générateur (6), agencé pour identifier une présence du train d'impulsions (65) dans le signal représentatif du courant primaire (42).

2. Dispositif de test selon la revendication 1 **caractérisé en ce que** le train d'impulsions (65) est composé d'impulsions (66) ayant une fréquence spécifique pour chaque seuil de déclenchement sélectionné (Sd).

3. Dispositif de test selon la revendication 2 **caractérisé en ce que** la fréquence des impulsions (66) correspondant à un seuil de déclenchement (Sd) donné est supérieure à la fréquence des impulsions correspondant à un seuil de déclenchement (Sd) plus élevé.

4. Dispositif de test selon la revendication 3 **caractérisé en ce que** la fréquence des impulsions (66) est supérieure à 300 Hz pour un seuil de déclenchement (Sd) égal à 30 mA.

5. Dispositif de test selon la revendication 4 **caractérisé en ce que** la fréquence des impulsions (66) est inférieure à 100 Hertz pour un seuil de déclenchement (Sd) supérieur à 1 A.

6. Dispositif de test selon la revendication 1 **caractérisé en ce que** le train d'impulsions (65) comporte une suite d'impulsions (66) dont la fréquence et le rapport cyclique forment un motif identifiable par le circuit de traitement (7).

7. Dispositif de test selon la revendication 6 **caractérisé en ce que** le motif identifiable par le circuit de traitement (7) est spécifique pour chaque seuil de déclenchement (Sd) sélectionné.

8. Dispositif de test selon l'une quelconque des revendications 1 à 7 **caractérisé en ce que** les impulsions (66) comportent une composante continue.

9. Dispositif de test selon la revendication 8 **caractérisé en ce que** le circuit de traitement (7) comporte un module pour identifier la présence de la composante continue dans le signal représentatif du courant primaire (42).

10. Dispositif de test selon l'une quelconque des revendications précédentes **caractérisé en ce que** le train d'impulsions (65) généré dans le deuxième enroulement secondaire (33) est constitué d'impulsions (66) d'amplitude constante.

11. Dispositif de test selon l'une des revendications 1 à 10 **caractérisé en ce que** le circuit de traitement (7) émet un signal d'alerte (71) en l'absence d'identification du train d'impulsions (65) dans le signal représentatif du courant primaire (42) quand le générateur (6) génère un train d'impulsions (65) dans le deuxième enroulement secondaire (33).

12. Appareil de protection (2) d'un réseau électrique, comportant :
- un transformateur de courant (3) composé d'un circuit magnétique (30) disposé autour d'au moins un conducteur de courant (31) dans lequel circule un courant primaire (Ip) formant un circuit primaire, ledit transformateur de courant (3) comprenant un premier enroulement secondaire (32) enroulé sur le circuit magnétique (30),
- un circuit de mesure (4) connecté au premier enroulement secondaire (32), le circuit de mesure comportant un filtre passe-bas du deuxième ordre (44) et étant agencé pour fournir, après filtrage par le filtre passe-bas du deuxième ordre, un signal représentatif du courant primaire (42) et une mesure du courant primaire (41),
- un interrupteur de courant (9) pour établir ou pour interrompre la circulation d'un courant électrique dans le, au moins un, conducteur de courant (31),
- un actionneur (8) pour actionner l'ouverture de l'interrupteur de courant (9),
- un circuit de déclenchement (5), relié au circuit de mesure (4), comportant des moyens de sélection d'un seuil de déclenchement (Sd), et agencé pour activer l'actionneur (8), et
- un dispositif de test (1) selon l'une des revendications 1 à 11.

13. Procédé de test d'un appareil de protection comportant un dispositif de test selon l'une des revendications 1 à 11, le procédé de test comportant :
- l'acquisition (110) d'une mesure d'un courant primaire (41),
- l'acquisition (120) d'une valeur d'un seuil de déclenchement sélectionné (Sd),
- la détermination (130) d'un seuil de courant minimal (Smini) associé au seuil de déclenchement sélectionné (Sd),
- la comparaison (140) entre la mesure du courant primaire (41) et le seuil de courant minimal (Smini) et, si la mesure du courant primaire (41) est inférieure au seuil minimal (Smini),
- la génération (150) d'un train d'impulsions spécifique au seuil de déclenchement sélectionné,
- l'acquisition (160) d'un signal représentatif du courant primaire (42),
- l'identification (170) d'une présence du train d'impulsions (65) ou d'une présence d'une composante continue (Uc) dans le signal représentatif du courant primaire (42), et
- l'émission (180) d'un signal d'alerte (71) sur une sortie d'alerte en l'absence d'identification du train d'impulsions (65) dans le signal représentatif du courant primaire (42).

## Patentansprüche

1. Testvorrichtung (1) des Betriebs eines Schutzgeräts (2) eines Stromnetzes,
wobei das Schutzgerät (2) aufweist:
- einen Stromwandler (3) bestehend aus einem Magnetkreis (30), der um mindestens einen Stromleiter (31) herum angeordnet ist, in dem ein Primärstrom (Ip) fließt, der einen Primärstromkreis bildet, wobei der Wandler eine auf den Magnetkreis (30) gewickelte erste Sekundärwicklung (32) enthält,
- einen mit der ersten Sekundärwicklung (32) verbundenen Messkreis (4), wobei der Messkreis ein Tiefpassfilter zweiter Ordnung (44) aufweist und eingerichtet ist, um nach dem Filtern durch das Tiefpassfilter zweiter Ordnung ein für den Primärstrom (42) repräsentatives Signal und einen Messwert des Primärstroms (41) zu liefern, und
- einen mit dem Messkreis (4) verbundenen Auslösekreis (5), der Auswahleinrichtungen einer Auslöseschwelle (55) aufweist,
und wobei die Testvorrichtung (1) aufweist:
- eine auf den Magnetkreis (30) gewickelte zweite Sekundärwicklung (33),
- einen mit dem Auslösekreis (5) verbundenen Generator (6), um die Erfassung der ausgewählten Auslöseschwelle (Sd) durchzuführen, und der eingerichtet ist, um eine Impulsfolge (65) in der zweiten Sekundärwicklung (33) gemäß einem Frequenzprofil derart zu erzeugen, dass der Messwert der Impulsfolge (65) nach dem Durchgang durch das Tiefpassfilter zweiter Ordnung (44) niedriger ist als die ausgewählte Auslöseschwelle (Sd), und
- einen mit dem Messkreis (4) und dem Generator (6) verbundenen Verarbeitungskreis (7), der eingerichtet ist, um ein Vorhandensein der Impulsfolge (65) im für den Primärstrom (42) repräsentativen Signal zu erkennen.

2. Testvorrichtung nach Anspruch 1, **dadurch gekennzeichnet, dass** die Impulsfolge (65) aus Impulsen (66) besteht, die für jede ausgewählte Auslöseschwelle (Sd) eine spezifische Frequenz haben.

3. Testvorrichtung nach Anspruch 2, **dadurch gekennzeichnet, dass** die Frequenz der Impulse (66) entsprechend einer gegebenen Auslöseschwelle (Sd) höher ist als die Frequenz der Impulse entsprechend einer höheren Auslöseschwelle (Sd).

4. Testvorrichtung nach Anspruch 3, **dadurch gekennzeichnet, dass** die Frequenz der Impulse (66) für eine Auslöseschwelle (Sd) gleich 30 mA höher ist als 300 Hz.

5. Testvorrichtung nach Anspruch 4, **dadurch gekennzeichnet, dass** die Frequenz der Impulse (66) für eine Auslöseschwelle (Sd) höher als 1A niedriger ist als 100 Hertz.

6. Testvorrichtung nach Anspruch 1, **dadurch gekennzeichnet, dass** die Impulsfolge (65) eine Folge von Impulsen (66) aufweist, deren Frequenz und Taktverhältnis ein vom Verarbeitungskreis (7) erkennbares Muster bilden.

7. Testvorrichtung nach Anspruch 6, **dadurch gekennzeichnet, dass** das vom Verarbeitungskreis (7) erkennbare Muster für jede ausgewählte Auslöseschwelle (Sd) spezifisch ist.

8. Testvorrichtung nach einem der Ansprüche 1 bis 7, **dadurch gekennzeichnet, dass** die Impulse (66) einen Gleichstromanteil aufweisen.

9. Testvorrichtung nach Anspruch 8, **dadurch gekennzeichnet, dass** der Verarbeitungskreis (7) ein Modul aufweist, um das Vorhandensein des Gleichstromanteils im für den Primärstrom (42) repräsentativen Signal zu erkennen.

10. Testvorrichtung nach einem der vorhergehenden Ansprüche, **dadurch gekennzeichnet, dass** die in der zweiten Sekundärwicklung (33) erzeugte Impulsfolge (65) aus Impulsen (66) konstanter Amplitude besteht.

11. Testvorrichtung nach einem der Ansprüche 1 bis 10, **dadurch gekennzeichnet, dass** der Verarbeitungskreis (7) in Abwesenheit einer Erkennung der Impulsfolge (65) im für den Primärstrom (42) repräsentativen Signal ein Warnsignal (71) sendet, wenn der Generator (6) eine Impulsfolge (65) in der zweiten Sekundärwicklung (33) erzeugt.

12. Schutzgerät (2) eines Stromnetzes, das aufweist:
- einen Stromwandler (3) bestehend aus einem Magnetkreis (30), der um mindestens einen Stromleiter (31) herum angeordnet ist, in dem ein Primärstrom (Ip) fließt, der einen Primärstromkreis bildet, wobei der Stromwandler (3) eine auf den Magnetkreis (30) gewickelte erste Sekundärwicklung (32) enthält,
- einen mit der ersten Sekundärwicklung (32) verbundenen Messkreis (4), wobei der Messkreis ein Tiefpassfilter zweiter Ordnung (44) aufweist und eingerichtet ist, um nach der Filterung durch das Tiefpassfilter zweiter Ordnung ein für den Primärstrom (42) repräsentatives Signal und einen Messwert des Primärstroms (41) zu liefern,
- einen Stromschalter (9), um das Fließen eines elektrischen Stroms in dem mindestens einen Stromleiter (31) herzustellen oder zu unterbrechen,
- einen Aktuator (8), um die Öffnung des Stromschalters (9) zu betätigen,
- einen mit dem Messkreis (4) verbundenen Auslösekreis (5), der Auswahleinrichtungen einer Auslöseschwelle (Sd) aufweist und eingerichtet ist, um den Aktuator (8) zu aktivieren, und
- eine Testvorrichtung (1) nach einem der Ansprüche 1 bis 11.

13. Testverfahren eines Schutzgeräts, das eine Testvorrichtung nach einem der Ansprüche 1 bis 11 aufweist, wobei das Testverfahren aufweist:
- die Erfassung (110) eines Messwerts eines Primärstroms (41),
- die Erfassung (120) eines Werts einer ausgewählten Auslöseschwelle (Sd),
- die Bestimmung (130) einer der ausgewählten Auslöseschwelle (Sd) zugeordneten minimalen Stromschwelle (Smini),
- den Vergleich (140) zwischen dem Messwert des Primärstroms (41) und der minimalen Stromschwelle (Smini), und wenn der Messwert des Primärstroms (41) niedriger ist als die minimale Schwelle (Smini),
- die Erzeugung (150) einer für die ausgewählte Auslöseschwelle spezifischen Impulsfolge,
- die Erfassung (160) eines für den Primärstrom (42) repräsentativen Signals,
- die Erkennung (170) eines Vorhandenseins der Impulsfolge (65) oder eines Vorhandenseins eines Gleichstromanteils (Uc) im für den Primärstrom (42) repräsentativen Signal, und
- das Senden (180) eines Warnsignals (71) an einem Warnausgang in Abwesenheit einer Erkennung der Impulsfolge (65) im für den Primärstrom (42) repräsentativen Signal.

## Claims

1. Device (1) for testing the operation of a protection unit (2) of an electrical network,
said protection unit (2) including:
- a current transformer (3) composed of a magnetic circuit (30) positioned around at least one current conductor (31) through which a primary current (Ip) flows forming a primary circuit, said transformer comprising a first secondary winding (32) wound around the magnetic circuit (30);
- a measurement circuit (4), connected to the first secondary winding (32), the measurement circuit including a second-order low-pass filter (44), and arranged to deliver, after filtering through the second-order low-pass filter, a signal that is representative of the primary current (42) and a measurement of the primary current (41); and
- a trip circuit (5), linked to the measurement circuit (4), including means for selecting a trip threshold (55),
And said test device (1) including:
- a second secondary winding (33) wound around the magnetic circuit (30);
- a generator (6), linked to the trip circuit (5) so as to acquire the selected trip threshold (Sd), and arranged to generate a pulse train (65) in the second secondary winding (33) according to a profile of frequencies such that the measurement of the pulse train (65) after passage through the second-order low-pass filter (44) is lower than the selected trip threshold (Sd); and
- a processing circuit (7), connected to the measurement circuit (4) and to the generator (6), arranged to identify a presence of the pulse train (65) in the signal that is representative of the primary current (42).

2. Test device according to Claim 1, **characterized in that** the pulse train (65) is composed of pulses (66) having a specific frequency for each selected trip threshold (Sd).

3. Test device according to Claim 2, **characterized in that** the frequency of the pulses (66) corresponding to a given trip threshold (Sd) is higher than the frequency of the pulses corresponding to a higher trip threshold (Sd).

4. Test device according to Claim 3, **characterized in that** the frequency of the pulses (66) is higher than 300 Hz for a trip threshold (Sd) that is equal to 30 mA.

5. Test device according to Claim 4, **characterized in that** the frequency of the pulses (66) is lower than 100 Hz for a trip threshold (Sd) that is higher than 1 A.

6. Test device according to Claim 1, **characterized in that** the pulse train (65) includes a series of pulses (66), the frequency and the duty cycle of which form a pattern that can be identified by the processing circuit (7).

7. Test device according to Claim 6, **characterized in that** the pattern that can be identified by the processing circuit (7) is specific for each selected trip threshold (Sd).

8. Test device according to any one of Claims 1 to 7, **characterized in that** the pulses (66) include a DC component.

9. Test device according to Claim 8, **characterized in that** the processing circuit (7) includes a module for identifying the presence of the DC component in the signal that is representative of the primary current (42).

10. Test device according to any one of the preceding claims, **characterized in that** the pulse train (65) generated in the second secondary winding (33) consists of constant-amplitude pulses (66).

11. Test device according to one of Claims 1 to 10, **characterized in that** the processing circuit (7) transmits an alert signal (71) in the absence of identification of the pulse train (65) in the signal that is representative of the primary current (42) when the generator (6) generates a pulse train (65) in the second secondary winding (33).

12. Protection unit (2) of an electrical network including:
- a current transformer (3) composed of a magnetic circuit (30) positioned around at least one current conductor (31) through which a primary current (Ip) flows forming a primary circuit, said current transformer (3) comprising a first secondary winding (32) wound around the magnetic circuit (30);
- a measurement circuit (4), connected to the first secondary winding (32), the measurement circuit including a second-order low-pass filter (44), and arranged to deliver, after filtering through the second-order low-pass filter, a signal that is representative of the primary current (42) and a measurement of the primary current (41);
- a current switch (9) for establishing or for interrupting the flow of an electric current in the, at least one, current conductor (31);
- an actuator (8) for actuating the opening of the current switch (9);
- a trip circuit (5), linked to the measurement circuit (4), including means for selecting a trip threshold (Sd), and arranged to activate the actuator (8), and
- a test device (1) according to one of Claims 1 to 11.

13. Method for testing a protection unit including a test device according to one of Claims 1 to 11, the test method including:
- acquiring (110) a measurement of a primary current (41);
- acquiring (120) a value of a selected trip threshold (Sd);
- determining (130) a minimum current threshold (Smini) that is associated with the selected trip threshold (Sd);
- comparing (140) the measurement of the primary current (41) with the minimum current threshold (Smini) and, if the measurement of the primary current (41) is lower than the minimum threshold (Smini);
- generating (150) a pulse train that is specific to the selected trip threshold;
- acquiring (160) a signal that is representative of the primary current (42);
- identifying (170) a presence of the pulse train (65) or a presence of a DC component (Uc) in the signal that is representative of the primary current (42); and
- transmitting (180) an alert signal (71) to an alert output in the absence of identification of the pulse train (65) in the signal that is representative of the primary current (42).
